(19) Europäisches Patentamt

European Patent Office

Office européen des brevets

(11) EP 1 616 995 A1

(12) EUROPEAN PATENT APPLICATION
published in accordance with Art. 158(3) EPC

(43) Date of publication:
18.01.2006 Bulletin 2006/03

(51) Int Cl.:
*D21H 13/40* (1990.01)    *B29B 11/16* (1985.01)
*H05K 1/03* (1980.01)

(21) Application number: 04728681.0

(22) Date of filing: 21.04.2004

(86) International application number:
**PCT/JP2004/005742**

(87) International publication number:
**WO 2004/094724 (04.11.2004 Gazette 2004/45)**

(84) Designated Contracting States:
**AT BE BG CH CY CZ DE DK EE ES FI FR GB GR
HU IE IT LI LU MC NL PL PT RO SE SI SK TR**
Designated Extension States:
**AL HR LT LV MK**

(30) Priority: **22.04.2003 JP 2003116883**

(71) Applicant: OJI PAPER CO., LTD.
Tokyo 104-0061 (JP)

(72) Inventors:
• **NISHIKORI, Yoshiharu,**
**c/o OJI PAPER CO., LTD.**
**Tokyo 1350062 (JP)**
• **TERAO, Tomoyuki,**
**c/o OJI PAPER CO., LTD.**
**Tokyo 1350062 (JP)**

(74) Representative: **Wilson, Gary et al**
**Marks & Clerk Scotland**
**19 Royal Exchange Square**
**Glasgow G1 3AE (GB)**

(54) **WET-PROCESS NONWOVEN FABRIC AND PROCESS FOR PRODUCING THE SAME**

(57)    The present invention provides a wet-spun non-women fabric composed of inorganic fibers containing bundled inorganic fibers and a binder components for binding the fibers, wherein the average number of the fibers in each bundle is 1.5 to 20 and the average Z/X value represented by the following formula in the cross section of the non-women fabric is 0.9 or below

(number of adjacent fibers in the thickness direction in each bundle) / (number of adjacent fibers in the plane direction in each bundle) = Z/X,

and a method for producing a wet-spun non-women fabric, which comprises the steps of dispersing inorganic fibers in an aqueous medium in the presence of an anionic dispersion stabilizer, adding a cationic compound to the obtained fiber dispersion to bundle the fibers and thereby preparing a fiber dispersion containing the resultant fiber bundles, marking a sheet from the obtained fiber dispersion containing the fiber bundles by wet method and applying a binder to the obtained sheet. The non-women fabric is a non-women inorganic fiber fabric having a high density.

EP 1 616 995 A1

## FIG. 7

200 μm

**Description**

Background of the Invention

The present invention relates to a wet-spun non-woven fabric made of inorganic fibers and a method for producing it. In particular, the present invention relates to a wet-spun non-woven fabric having a high density and a method for producing it.

In moldings such as FRP (fiber reinforced plastics) made of a non-woven inorganic fiber fabric, FRTP (fiber reinforced thermo-plastics), prepregs for printed circuits and laminate plates, the plastic strength thereof is improved with a non-woven fabric. For improving the effect of the non-woven fabric, it is required to increase the relative amount of the non-woven fabric in the moldings or, in other words, to increase the density of the non-woven fabric. Although a calendar technique is usually employed for increasing the density in this technical field, it is difficultly used for inorganic fibers because the fibers themselves are easily broken. Under these circumstances, methods for increasing the density as will be described below have been proposed.

There has been already proposed a method for improving the impact resistance of FRP by incorporating at least 20 % by mass of fiber bundles each comprising at least 100 fibers into a wet spun non-woven fabric composed of a binder component which can be combined with the inorganic fibers (Japanese Patent Unexamined Published Application (hereinafter referred to as "J. P. KOKAI No. Hei 10-292254)). However, the non-woven fabric containing at least 20 % by mass of bundles each comprising at least 100 the inorganic fibers has a problem of a poor texture when the non-woven fabric is thin.

A method for improving the texture of the non-woven fabric was proposed (refer to J. P. KOKAI No. Hei 4-298208). This method comprises steps of dispersing glass fibers with a betaine-type surfactant, improving the dispersibility of the fibers and stability of the dispersibility with an anionic polyacrylamide as a viscosity increaser to prepare a wet sheet having an improved texture and incorporating a binder paint containing a water-soluble strength additive having a cation group into the wet sheet to form the non-woven fabric. However, the improvement in the density cannot be expected by this method because the method is for producing ordinary non-woven glass fabrics in which the fibers are dispersed separately.

In the production of non-woven fabrics from inorganic fibers by a paper-making technique, a binder component is often used for reinforcing the non-woven fabrics because the inorganic fibers themselves have no adhesive power. However, the density of non-woven fabrics composed of the ordinary inorganic fibers and binder component was at the highest about 0.2 g/cm$^3$ (for example, J. P. Kokai No. Sho 62-41399 (page. 1 and Conventional Examples on pages 5 and 6) and J. P. Kokai No. 2000-64167 (Examples and Comparative Examples on pages 3 to 5)).

For improving the density of non-woven fabrics, a method wherein the heating treatment is conducted under a pressure of at least 150 g/cm$^2$ was proposed (Patent No. 3157265) . By this method, non-woven inorganic fabrics having a density of at least 0.153 g/cm$^3$ can be obtained. However, according to the results obtained in Examples thereof, a density of 0.12 to 0.14 g/cm$^3$ of the fabrics is increased to at the highest about 0.18 g/cm$^3$ by the heat treatment under pressure.

A method wherein small diameter fibers having an average diameter of 3 $\mu$m or less typified by micro-glass fibers are incorporated into inorganic fibers in a non-woven fabric and further a filler is incorporated into the non-woven fabric of the inorganic fibers (J. P. Kokai No. Sho 62-41399). According to this method, the total surface area of the fibers in the non-woven fabric is increased by using the combination with the small diameter fibers, the filler can be kept on the fiber surface by using the plural high-molecular substances having different ionic properties, and the density of the non-woven fabric can be improved by increasing the amount of the filler incorporated into the non-woven fabric. It is understood from the results obtained in Examples and Comparative Examples that when the small diameter fibers are not used, the density of the non-woven fabric is 0.18 g/cm$^3$ and the effect in improving the density is only slight. Because the inorganic fibers having the small diameter themselves exert a bad influence on the human bodies like asbestos, they should be used under a severe control or a method wherein the small diameter fibers are not used is required.

For improving the density of non-woven inorganic fiber fabric without using the small diameter fibers, a method wherein glass fibers having a non-circular cross section such as elliptic, oval, cocoon-shaped or flat cross section are used was proposed (refer to, for example, Japanese Patent Publication for Opposition Purpose (hereinafter referred to as "J. P. KOKOKU") No. Hei 7-122235 and J. P. KOKAI No. Hei 11-172559). Although this method greatly contributes to the improvement in the density, inorganic fibers having such non-circular cross section cost high and even they are not easily available because they are special and produced in only a small amount.

Disclosure of the Invention

The object of the present invention is to provide non-woven inorganic fiber fabrics having a high density. Namely, object of the present invention is to provide non-woven inorganic fiber fabrics having a high density by a method different from the method wherein fibers having a small diameter are used or from the method wherein inorganic fibers having a flat cross section are used.

Another object of the present invention is to provide a method for producing such non-woven inorganic fiber fabrics having a high density.

Still another object of the present invention is to provide prepregs and/or laminates.

After intensive investigations, the inventors have solved the above-described problems by a method wherein at least a half of inorganic fibers in a wet-spun non-woven fabric are in the form of bundles of two or more fibers and each of the many fiber bundles is arranged not in the thickness direction of the non-woven fabric but in the plane direction.

Namely, the present invention is as follows:

[1] A wet-spun non-woven fabric composed of inorganic fibers containing bundled inorganic fibers and a binder component for binding the fibers, wherein the average number of the fibers in each bundle is 1.5 to 20 and the average Z/X value represented by the following formula in the cross section of the non-woven fabric is 0.9 or below:

$$\text{(number of adjacent fibers in the thickness direction in each bundle)} / \text{(number of adjacent fibers in the plane direction in each bundle)} = Z/X.$$

[2] The wet-spun non-woven fabric of above item [1] wherein the maximum number of fibers in the bundle is not larger than 100.

[3] The wet-spun non-woven fabric of above item [1] or [2] wherein the average diameter of the inorganic fibers is 4 $\mu$m to 20 $\mu$m and the average fiber length is 1 mm to 25 mm.

[4] The wet-spun non-woven fabric of any of above items [1] to [3] wherein the inorganic fibers are glass fibers.

[5] The wet-spun non-woven fabric of any of above items [1] to [4], which has a density of 0.20 g/cm$^3$ to 1.20 g/cm$^3$.

[6] The wet-spun non-woven fabric of any of above items [1] to [5], which has a binder content of 3 % by mass to 18 % by mass and a density of 0.20 g/cm$^3$ to 0.50 g/cm$^3$.

[7] The wet-spun non-woven fabric of any of above items [1] to [5], which has a binder content of 50 % by mass to 90 % by mass and a density of 0.40 g/cm$^3$ to 1.20 g/cm$^3$.

[8] A method for producing a wet-spun non-woven fabric of any of above items [1] to [7], which comprises the steps of dispersing inorganic fibers in an aqueous medium in the presence of an anionic dispersion stabilizer, adding a cationic compound to the obtained fiber dispersion to bundle the fibers and thereby preparing a fiber dispersion containing the resultant fiber bundles, making a sheet from the obtained fiber dispersion containing the fiber bundles by wet method and applying a binder to the obtained sheet.

[9] A method for producing a wet-spun non-woven fabric of any of above items [1] to [7], which comprises the steps of dispersing inorganic fibers in an aqueous medium in the presence of a cationic dispersion stabilizer, adding a anionic compound to the obtained fiber dispersion to bundle the fibers and thereby preparing a fiber dispersion containing the resultant fiber bundles, making a sheet from the obtained fiber dispersion containing the fiber bundles by wet method and applying a binder to the obtained sheet.

[10] A method for producing a wet-spun non-woven fabric of any of above items [1] to [7], which comprises the steps of dispersing a part of inorganic fibers in an aqueous medium in the presence of an anionic dispersion stabilizer, dispersing a part of the inorganic fibers or the remainder of the inorganic fibers in an aqueous medium in the presence of a cationic dispersion stabilizer to prepare a cationic fiber dispersion and thereby preparing at least two fiber dispersions, mixing the at least two fiber dispersions together to bundle the fibers and to prepare a fiber dispersion containing the fiber bundles, making a sheet from the obtained fiber dispersion containing the fiber bundles by wet method and applying a binder to the obtained sheet.

[11] Prepregs and/or laminates containing the wet-spun non-woven fabric of any of above items [1] to [7].

[12] Prepregs and/or laminates for printed circuits, which contain the wet-spun non-woven fabric having a thickness of 300 $\mu$m or less of any of above items [1] to [7].

[13] A method for producing a wet-spun non-woven fabric, which comprises the steps of dispersing inorganic fibers in an aqueous medium in the presence of an anionic dispersion stabilizer and a nonionic surfactant, adding a polyethyleneimine to the obtained fiber dispersion to bundle the fibers and thereby preparing a fiber dispersion containing the resultant fiber bundles, making a sheet from the obtained fiber dispersion containing the fiber bundles by wet method and applying a binder to the obtained sheet.

[14] A method for producing a wet-spun non-woven fabric, which comprises the steps of dispersing inorganic fibers in an aqueous medium in the presence of a polyethyleneimine and a nonionic surfactant, adding an anionic compound to the obtained fiber dispersion to bundle the fibers and thereby preparing a fiber dispersion containing the resultant fiber bundles, making a sheet from the obtained fiber dispersion containing the fiber bundles by wet method and applying a binder to the obtained sheet.

Brief Description of the Drawings

Fig. 1 is a schematic view obtained by the observation of the surface of a non-woven fabric.

Fig. 2 is a schematic view of the cross section obtained by the observation of the cross section of a non-woven fabric.

Fig. 3 is a schematic view of the cross section obtained by the observation of the cross section of a non-woven fabric.

Fig. 4 is a schematic view obtained by the observation of the surface of a non-woven fabric.

Fig. 5 is a schematic view of the cross section obtained by the observation of the cross section of a non-woven fabric.

Fig. 6 is a schematic view of the cross section obtained by the observation of the cross section of a non-woven fabric.

Fig. 7 is a photograph of the surface of a non-woven fabric of the present invention produced in Example 1 and observed with an optical microscope.

Fig. 8 is a photograph of the cross section of a non-woven fabric of the present invention produced in Example 1 and observed with SEM.

Fig. 9 is a photograph of the cross section of a non-woven fabric produced in Comparative Example 1 and observed with SEM.

Fig. 10 is a photograph of the surface of a non-woven fabric of the present invention produced in Example 2 and observed with an optical microscope.

Fig. 11 is a photograph of the surface of a non-woven fabric of the present invention produced in Example 3 and observed with an optical microscope.

Fig. 12 is a photograph of the surface of a non-woven fabric of the present invention produced in Example 4 and observed with an optical microscope.

Fig. 13 is a photograph of the surface of a non-woven fabric of the present invention produced in Example 5 and observed with an optical microscope.

Fig. 14 is a photograph of the surface of a non-woven fabric of the present invention produced in Example 6 and observed with an optical microscope.

Fig. 15 is a photograph of the surface of a non-woven fabric produced in Comparative Example 1 and observed with an optical microscope.

Fig. 16 is a photograph of the surface of a non-woven fabric produced in Comparative Example 2 and observed with an optical microscope.

Fig. 17 is a photograph of the surface of a non-woven fabric produced in Comparative Example 3 and observed with an optical microscope.

Best Mode for Carrying out the Present Invention

In the present invention, the word "bundle" indicates two or more fibers bonded together. For producing the wet-spun non-woven fabric of the present invention, three methods which will be described below are preferred. In the bundles of the fibers in the non-woven fabric produced by these methods, fibers in each bundle are arranged in the lengthwise direction in the bundling step because as the surface area of the whole fibers is smaller, the surface energy is more stable. This fact is understood by the observation of the surface of the non-woven fabric with a microscope.

In the present invention, the average number of the fibers in a bundle, the maximum number of the fibers in a bundle and average Z/X value can be determined from the number of fibers in each bundle, the number of fibers (Z) adjacent to each other in the thickness direction of the non-woven fabric and the number of fibers (X) adjacent to each other in the plane direction. These numbers can be determined from the results of the observation of the surface of the non-woven fabric with a microscope. On the other hand, when the fibers are piled up in the thickness direction, the state of the bundling of the fibers in the thickness direction and also the state of bundling of the fibers in 1 direction (X direction) in the plane can be accurately examined by the observation of the cross section of the non-woven fabric with a microscope.

In the present invention, the word "bundle" indicates "two or more fibers bonded together in the longitudinal direction as found by the observation of the cross section of a non-woven fabric". The expression "bonded together" herein indicates such a state that the fibers are closely adhered to each other or the fibers gathered together in the longitudinal direction within at least 1/2 diameter of the fiber. The following methods can be mentioned for concretely determining the state of the fibers bonded in the longitudinal direction: Method 1: The surface of the non-woven fabric is observed, the fibers are classified into groups of those bundled in the longitudinal direction and others, the cross section of the classified fibers is observed and the state of the fibers is determined with reference to the classification of the observed surface. Method 2: When the fibers are regularly arranged in the longitudinal direction in most of the fiber bundles, the fibers bonded together can be determined as bundled fibers by the observation of the cross section thereof. Also when a most part of the fibers is not bundled, the state of them can be found by the observation of the cross section thereof. Namely, at first, the surface of a given area which has a typical state of the non-woven fabric is observed to judge whether most bundles of the fibers are uniformly arranged in the longitudinal direction or most of the fibers are not bundled. When most fiber bundles are arranged in the longitudinal direction or most fibers are not bundled, the cross section of the part, the surface of which was observed, is observed to find the bonded fibers as the bundled fibers.

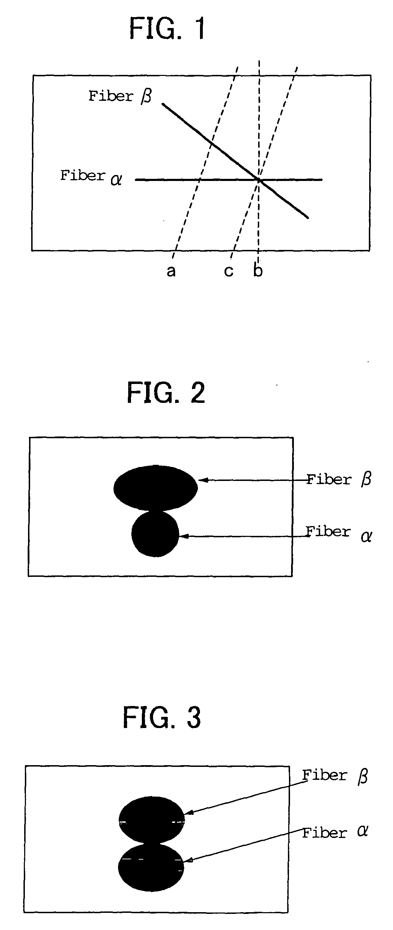

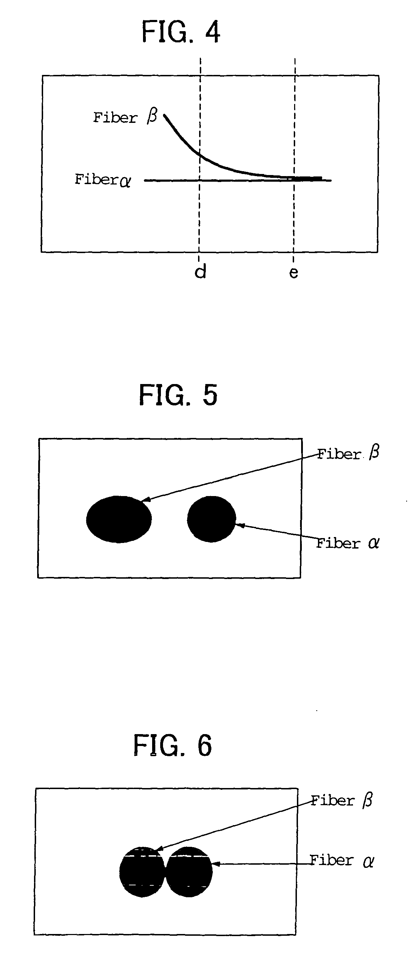

In judging the fibers bonded together in the longitudinal direction only by the observation of the cross section as in method 2, the fibers are judged to be bundled when the cross section thereof is as shown in Fig. 3 or Fig. 6. However, the results obtained by method 2 have some error in the results as compared with those obtained by method 1. More concretely, in the observation schematic view of Fig. 1 wherein the circular cross section of fibers $\alpha$ and that of fibers $\beta$ are observed in the surface direction, it is clear that fibers $\alpha$ and $\beta$ are not bonded with each other in the observation of the cross section a. Further, in cross section b (Fig. 2), the fibers are not bonded in the longitudinal direction because the fibers have cross sections different from each other. On the other hand, in cross section c, the fibers are judged to be bundled because the shape of the cross section is similar to that shown in Fig. 3. However, it is obvious that the probability of the cross section to be c is low. As a result, the error in the average Z/X value is only slight. Also in Fig. 4, the schematic views of the cross sections are as shown in Figs. 5 and 6. However, when most of the bundles of the fibers are arranged in the longitudinal direction, a case like that shown in Fig. 4 is very rare. Thus, the error is only slight.

In the observation of the cross section of the non-woven fabric, the cross section may be directly observed with a microscope. In other methods of the observation, the non-woven fabric is embedded in a resin and then the non-woven fabric is sliced with a microtome or the like to obtain the cross section of the fabric; or moldings prepared from the non-woven fabric of the present invention such as FRP (Fiber Reinforced Plastics), FRTP (Fiber Reinforced Thermo-Plastics), prepregs for printed circuits and laminates are sliced with the microtome or the like to obtain the cross sections of the non-woven fabrics to be observed. In all the cases, fiber bundles and free fibers which are not bundled are contained at random in the non-woven fabric of the present invention. This state can be clearly understood by the observation of the cross section of the fabric.

In the determination of the average number of the fibers in a bundle, the maximum number of fibers in a bundle and Z/X value, the word "bundle" indicates a bunch of bundled fibers. When fibers are not bundled and separately exist in the non-woven fabric, each fiber in the fibers is counted as one bundle. The area of the cross section for counting the number of the fibers is at least 0.2 mm$^2$, preferably at least 0. 4 mm$^2$ and particularly 0.4 mm$^2$ to 1.4 mm$^2$. The number of the times of the observation for a non-woven fabric is preferably at least 3, particularly 5. In the present invention, only the inorganic fibers are counted.

The average number of the fibers in a bundle is defined by formula 1:

[Formula 1]

$$[\text{Average number of fibers in a bundle}]$$

$$= [\text{Total number of fibers}] / [\text{total number of bundles}]$$

In the present invention, the maximum number of the fibers in the bundle is defined to be the minimum number of n in the following formula 2:

[Formula 2]

$$\frac{\sum_{i=1}^{n} (i \times p)}{[\text{total number of fibers}]} \geqq 0.85$$

wherein i represents the number of the fibers in the bundle, and p represents the number of the bundles of fibers of the number of i.

Z/X value of each bundle in the present invention is defined by formula 3, and the average Z/X value is defined by formula 4:

[Formula 3]

[Z/X value] = [number of adjacent fibers in the thickness direction in each bundle] / [number of adjacent fibers in the plane direction in each bundle]

[Formula 4]

[Average Z/X value] = [total of Z/X values] / [total number of bundles]

In the present invention, a part or the whole of the inorganic fibers is bundled, the average number of the fibers in the bundle is 1.5 to 20 and the average Z/X value is 0.9 or below. When the average number of the fibers in a bundle is over 20 and the non-woven fabric has a low basis weight, i. e. a thickness of 300 $\mu$m or lower, the formation of the fabric is very wild. In particular, when the basis weight is as low as 200 $\mu$m or lower, this tendency is remarkable. When the average number of the fibers in the bundle is below 1.5, the bundle does not contribute to the improvement in the density. The average number of the fibers in the bundle is preferably 2 to 15, more preferably 2.5 to 10. When the average Z/X value is over 0.9, the fibers do not remarkably contribute to the improvement in the density of the non-woven fabric. The average Z/X is preferably 0.85 or below, more preferably 0.35 to 0.85.

The maximum number of the fibers in the bundle is preferably 5 to 100, more preferably 5 to 80 and still more preferably 5 to 60.

The inorganic fibers usable in the present invention include ceramic fibers, glass fibers, carbon fibers, etc. and mixtures of two or more of them. In them, the glass fibers are preferred. The glass fibers include, for example, E glass fibers, D glass fibers, S glass fibers, NE glass fibers, E glass fibers, quartz glass fibers and high silica glass fibers.

The inorganic fibers used in the present invention preferably have a circular cross section. However, the object of the present invention can be attained irrespective of the shape of the cross section (for example, oval, cocoon-shaped, flat or star-shaped cross section) of the fibers. However, hollow fibers are not preferred because the fibers *per se* in the bundles have a low density.

The inorganic fibers used in the present invention have an average diameter (the average fiber diameter as converted into the circular fiber diameter) of preferably 4 $\mu$m to 20 $\mu$m and an average length of preferably 1 mm to 25 mm. More preferably, the inorganic fibers have an average diameter of 6 $\mu$m to 15 $\mu$m and an average length of 2 mm to 13 mm. The fibers having a size in this range are particularly preferred because there is no fear of damaging the health and the texture of the non-woven fabric is improved.

The relative amount of the non-bundled fibers in the non-woven fabric is not larger than 50 % by mass (hereinafter referred to as %), preferably not larger than 25 % and more preferably 1 to 25 % based on the number of the total inorganic fibers constituting the non-woven fabric in the present invention. The relative amount of the non-bundled fibers in this range is preferred because it contributes to the improvement in the density.

The density of the non-woven fabric of the present invention is preferably 0.20 g/cm$^3$ to 1.20 g/cm$^3$. The amount of the binder can be in the range of 3 % by mass to 90 % by mass. When the amount of the binder is in the range of 3 mass % to 18 mass %, the density is preferably 0.20 g/cm$^3$ to 0.50 g/cm$^3$, more preferably 0.23 g/cm$^3$ to 0.43 g/cm$^3$. When the amount of the binder is in the range of 50 mass % to 90 mass %, the density is preferably 0.40 g/cm$^3$ to 1.20 g/cm$^3$, more preferably 0.60 g/cm$^3$ to 1.10 g/cm$^3$ and most preferably 0.65 g/cm$^3$ to 1.05 g/cm$^3$. The amount of the binder can also be larger than 18 % and less than 50 %.

According to the method of the present invention, the non-woven fabric having an excellent impregnability with a resin and a high strength can be obtained even when the density is in a relatively low range of, for example, 0.1 to 0.25 g/cm$^3$, preferably 0.13 to 0.19 g/cm$^3$ and most preferably 0.16 to 0.19 g/cm$^3$.

The binder component used in the present invention is not particularly limited so far as it is a well-known binder component. The binder components include well-known organic binders such as acrylic resin, polyimide resin, urethane resin, polyvinyl alcohol, polyacrylamide, water-soluble cellulose, starch, SBR and epoxy resin; inorganic binders; well-known thermoplastic fibers such as m-aramid fibers, liquid crystal polymer fibers, thermoplastic polyimide fibers, polypropylene fibers, polyethylene terephthalate fibers, acrylic fibers, polyvinyl alcohol fibers and polystyrene fibers; and wood pulps such as KP, GP and TMP. One kind or a mixture of two or more kinds of the organic binders, inorganic binders and binder fibers is usable in the present invention.

When the amount of the binder is 50 % by mass or larger, the inorganic binders are preferred because the water absorption of the non-woven fabric prepared with the inorganic binder is lower than that of the fabric prepared with the organic binder or binder fibers.

The inorganic binders include precursors containing at least one of alkoxysilanes and polymers thereof or a product obtained by hydrolyzing and condensing the precursor. They also include mixtures of those binders. Further, they include substances having chemical structures substantially the same as those of the hydrolysis / condensation product of the alkoxysilane. The alkoxysilanes include, for example, $Si\text{-}(OR')_1$, $R\text{-}Si\text{-}(OR')_3$, $R_2\text{-}Si\text{-}(OR')_2$, $R_3\text{-}Si\text{-}OR'$, and $R_1\text{-}(R'O)_{3\text{-}i}Si\text{-}R\text{-}Si(OR')_{3\text{-}j}R_j$, wherein i and j each represent a natural number of 0 to 2, R and R' each represent an organic group and it is not indispensable that all R and R' groups in the formula are the same organic group. The organic groups include hydrocarbon groups such as alkyl groups (e. g. methyl group, ethyl group and propyl group) and aryl groups (e. g. phenyl group) and also hydrogen. The organic groups may also be organic functional groups composed of those hydrocarbon groups bonded with a functional group such as amino group, a halogen, epoxy group, urethane group, isocyanato group, mercapto group, sulfido group, vinyl group, acrylo group, acryloxyl group or methacryloxy group. Other organic groups are also included therein. The alkoxysilanes also include so-called silane coupling agents herein. Because substances having chemical structures substantially the same as those of the hydrolysis / condensation product of the alkoxysilane are generally called as alkoxysilane herein, silane halides having a halogen group in place of OR' group can be mentioned as examples of them. Well-known metal alkoxides can be mentioned as inorganic binder precursors other than the silicon compounds. The metal alkoxides include, for example, aluminum alkoxides ($R_nAl(OR')_{3\text{-}n}$), titanium alkoxides ($R_mTi(OR')_{4\text{-}m}$) and zirconium alkoxides ($R_mZr(OR')_{4\text{-}m}$). As a matter of course, the metal alkoxides are not limited to them. R and R' in the general formula each represent an organic group as mentioned above. R and R' each represent an organic group and it is not indispensable that all R and R' groups in the formula are the same organic group n represents an integer of 0 to 3 and m represents an integer of 0 to 4.

The non-woven fabric of the present invention can be produced by a wet method comprising a well-known paper making technique. The wet-spun non-woven fabric is characterized by having a formation better than that of non-woven fabrics obtained by another method.

Preferred production methods of the present invention are the following three methods.

The first method is a method for producing a wet-spun non-woven fabric, which comprises the steps of dispersing inorganic fibers in an aqueous medium in the presence of an anionic dispersion stabilizer, adding a cationic compound to the obtained fiber dispersion to bundle the fibers and thereby preparing a fiber dispersion containing the resultant fiber bundles, making a sheet from the obtained fiber dispersion containing the fiber bundles by wet method and applying a binder to the obtained sheet.

The second method is a method for producing a wet-spun non-woven fabric, which comprises the steps of dispersing inorganic fibers in an aqueous medium in the presence of a cationic dispersion stabilizer, adding a anionic compound to the obtained fiber dispersion to bundle the fibers and thereby preparing a fiber dispersion containing the resultant fiber bundles, making a sheet from the obtained fiber dispersion containing the fiber bundles by wet method and applying a binder to the obtained sheet.

The third method is a method for producing a wet-spun non-woven fabric, which comprises the steps of dispersing a part of inorganic fibers in an aqueous medium in the presence of an anionic dispersion stabilizer, dispersing a part of the inorganic fibers or the remainder of the inorganic fibers in an aqueous medium in the presence of a cationic dispersion stabilizer to prepare a cationic fiber dispersion and thereby preparing at least two fiber dispersions, mixing the at least two fiber dispersions together to bundle the fibers and to prepare a fiber dispersion containing the fiber bundles, making a sheet from the obtained fiber dispersion containing the fiber bundles by wet method and applying a binder to the obtained sheet.

All of the above-described three methods comprises a process wherein a dispersion of fibers having a small amount of fibers bonded together is prepared in the first process, a fiber dispersion containing fiber bundles is prepared in the second process and a non-woven fabric is prepared by a sheet making technique in the third process.

As for glass fiber chops, many of those available on the market are not separated from one another but dozens to several hundreds of the fibers are bonded together to form a bundle. The glass fiber chops are divided into substantially separate fibers to form an excellent fiber dispersion in the first process. When the commercially available glass fiber chops mostly in the bonded, non-dispersed form are used, the formation of the finally obtained non-woven fabric is wild. For obtaining highly dispersed fibers, water and fibers are added and they are stirred by a well-known method with, if necessary, a pulper. For realizing an excellent dispersion state of the fibers, a dispersion stabilizer is added to the fiber dispersion. The dispersion stabilizer is added in the course of the stirring or before or after the stirring.

As the anionic dispersion stabilizers used in the first process in the first method, well-known anionic surfactants and water-soluble anionic polymers can be mentioned. Preferred examples of them are alkyl sulfate esters, alkylbenzenesulfonates, alkylnaphthalenesulfonates, dialkylsulfosuccinates, alkyl diaryl ether sulfonates, alkylphosphates, naphthalenesulfonic acid / formalin condensates, polyoxyethylene alkyl and alkylaryl ether sulfate salts, carboxylic acid-type polymer activators, anionic polyacrylamides typified by carboxylic acid-modified polyacrylamides and acrylate / acrylamide copolymers, polyacrylic acid salts, alginic acid salts, carboxymethylcellulose and carboxymethylated guar gum. More preferred anionic dispersion stabilizers are anionic polyacrylamides and polyacrylic acid salts. Those anionic dispersion stabilizers are usable either alone or in combination of two or more of them. The anionic dispersion stabilizer is used in an amount of 0.1 to 10 %, preferably 0.5 to 5 %, based on the inorganic fibers.

For further improving the state of the fiber dispersion, it is preferred to use a nonionic surfactant so far as the anionic property of the fiber dispersion is not damaged. The nonionic surfactants include, for example, polyoxyethylene alkyl ethers, polyoxyethylene alkylphenyl ethers, hydroxyethylene / hydroxypropylene block polymers, sorbitan /fatty acid esters, polyoxyethylene sorbitan / fatty acid esters, fatty acid monoglycerides, polyethylene glycol / fatty acid esters and polyoxyethylenealkylamines. Preferred nonionic surfactants are polyethylene glycol fatty acid esters. The nonionic surfactant is used in an amount of not larger than 5 % by mass, preferably 0.1 to 3 % by mass, based on the inorganic fibers.

The cationic compounds used in the second process in the first method are preferably, for example, cationized modified acrylamides (concrete examples of the cationized modified acrylamides include those obtained by cationizing and modifying acrylamides by Mannich reaction, Hofmann reaction or the like), cationized acrylamides typified by copolymers of a cationic monomer and acrylamide, diarylammonium halides, polyvinylpyridine, nitrated acrylic resins, diamine-modified isobutylene / maleic anhydride copolymer, diamine-modified styrene /maleic anhydride copolymer, polyvinylimidazoline, dialkylaminoethyl arylates, chitosan, alkylene dichloride / alkylenepolyamine polycondensates, aniline / formalin polycondensate, alkylenediamine /epichlorohydrin polycondensates, ammonia / epichlorohydrin polycondensate, aspartic acid / hexamethylenediamine polycondensate, polyethyleneimine, polydimethyldiarylammonium chlorides, water-soluble aniline resin hydrochlorides, polyamines, polydiallyldimethylammonium chlorides, hexamethylenediamine /epichlorohydrin polycondensates, polyalkylamino acrylates or methacrylates, polyaluminum chlorides, alumina sulfate, aluminates, cationized modified guar gum, cationized modified starch, cationized modified polyvinyl alcohols, quaternary ammonium salts (such as lauryltrimethylammonium chloride, stearyltrimethylammonium chloride, distearyldimethylammonium chloride and alkylbenzyldimethyl ammonium chlorides), alkylamine salts (such as coconut amine acetate, stearylamine acetate, coconut amine hydrochloride, stearylamine hydrochloride and stearylamine oleate). In them, the cationized acrylamides and polyethyleneimine are preferred. The cationic compounds are used in an amount of preferably 0.05 to 7 %, more preferably 0.1 to 3 %, based on the inorganic fibers.

The cationic dispersion stabilizers used in the first process in the second method are preferably, for example, cationic compounds used in the second process in the first method. These stabilizers are, more preferably, cationic acrylamides and polyethyleneimines. The cationic dispersion stabilizer is used in an amount of 0.05 to 7 %, more preferably 0.1 to 3 %, based on 100 parts by mass of the inorganic fibers. It is desirable to use the cationic dispersion stabilizer in combination with a nonionic surfactant so far as the cationic property of the fiber dispersion is not damaged. The nonionic surfactants are, for example, those mentioned with reference to the first method. More preferred surfactants are polyethylene glycol fatty acid esters. The nonionic surfactant is used in an amount of 5 % by mass or less, preferably 0.1 to 3 % by mass and more preferably 0.5 to 3 % by mass, based on the inorganic fibers.

The anionic compounds used in the second process in the second method are preferably, for example, anionic dispersion stabilizers used in the first process in the first method. Anionic polyacrylamides and polyacrylic acid salts are more preferred. The anionic compounds are used in an amount of preferably 0.1 to 10 %, more preferably 0.5 to 5 %, based on the inorganic fibers.

The anionic fiber dispersion prepared in the first process in the third method is the same as the fiber dispersion in the first process in the first method, and the cationic fiber dispersion can be the same as the fiber dispersion in the first process in the second method.

The sheet making technique in the third process in the production in the present invention may be a known technique. Sheet machines are, for example, known paper machines such as Fourdrinear paper machine, cylinder paper machine, tilting wire machine and twin wire machine, and also hand paper machines used for the investigations on the laboratory level by those skilled in the art.

The main process for forming the form of the non-woven fabric having an average Z/X value of not higher than 0.9 is the third process. In particular, the non-woven fabric is formed in the step of making the fabric from a fiber dispersion containing fiber bundles in the wire part with the wire (the step in which the white water passes through the wire). In the present invention, the effect can be further improved by pressing a press roll or felt on the wire part and/or dryer part.

When binder fibers, or powdery organic binder or inorganic binder is used as the binding component in the present invention, the binder can be previously incorporated into the fiber dispersion containing the fiber bundles. On the other hand, when a liquid organic binder or inorganic binder is used as the binder component, the binder component is preferably fed and adhered to the wet sheet formed in the wire part and then dried in the dryer part to form the non-woven fabric. For improving the strength of the non-woven fabric, a binding component can be further applied to the non-woven fabric thus produced. Such an organic binder or inorganic binder can be applied by a well-known coating method such as impregnation method, spraying method, mayer rod method, gravure method, micro-gravure method, dyeing method, blade method, micro-rod method, air knife method, curtain method, sliding method or rolling method. As a matter of course, other well-known methods can also be employed.

In the present invention, a preferred method for producing the wet non-woven fabric is characterized by comprising the steps of dispersing inorganic fibers in an aqueous medium in the presence of an anionic dispersion stabilizer and a nonionic surfactant, adding polyethyleneimine to the obtained fiber dispersion to bundle the fibers and thereby preparing a fiber dispersion containing the resultant fiber bundles, making a sheet from the obtained fiber dispersion containing the fiber bundles by wet method and applying a binder to the obtained sheet. Another preferred method comprises the steps of dispersing inorganic fibers in an aqueous medium in the presence of a polyethyleneimine and a nonionic surfactant, adding an anionic compound to the obtained fiber dispersion to bundle the fibers and thereby preparing a fiber dispersion containing the resultant fiber bundles, making a sheet from the obtained fiber dispersion containing the fiber bundles by wet method and applying a binder to the obtained sheet.

The non-woven fabric of the present invention can contain, in addition to the binder component for binding the fibers and the inorganic fibers, auxiliary additives required for the production of the non-woven fabric by the wet method, auxiliary binders (such as silane coupling agents) for firmly binding the inorganic fibers with the binder component.

The non-woven fabric of the present invention is usable for forming FRP used as a building material, prepregs for printed circuits and laminates. It is particularly preferred to use this non-woven fabric for forming prepregs for printed circuits and laminates. Because the thickness of built-up layers is getting thinner due to the recent inclination of the miniaturization and high frequency signalization, the thickness of the non-woven fabric of the present invention is preferably 300 $\mu$m or less, more preferably 200 $\mu$m or less and most preferably 75 $\mu$m or less.

Well-known thermosetting resins are preferably usable as the resins with which the non-woven fabric of the present invention is impregnated for preparing a prepregs or laminate with this fabric. Particularly preferred resins are, for example, epoxy resin, phenolic resin, polyimide resin, cyanate resin and thermosetting polyphenylene oxide resin. If necessary, circuits made of copper foil or the like can be prepared on the prepregs or each layer of the laminate by a well-known method.

The following Examples will further concretely illustrate the present invention, which by no means limit the scope of the invention. Unless otherwise stated, percentages and parts are % by mass and parts by mass, respectively.

<Example 1>

In this Example, a combination of a water-soluble anionic polymer and a nonionic surfactant was used as the dispersion stabilizer.

E glass fiber chops having a diameter of round cross-section $\phi$ of 6 $\mu$m and a fiber length of 3 mm were mixed with 1 %, based on the fibers, of a nonionic surfactant, i. e. polyethylene glycol stearate (Emanon 3299; a product of Kao Corporation) in water in such a manner that the fiber concentration was kept at 0.02%, while stirring with Three-one motor. Then 100 parts of the dispersion prepared as described above was mixed with 0.1 part of 0.2 % solution of a mixture of an anionic polyacrylamide (an anionic water-soluble polymer) and polysodium acrylate (ACCOPEARL R-200; a product of Mitsui Cytec Ltd. (Now: Mitsui Chemical Aqua Polymer Inc.)) to prepare a fiber dispersion. It was macroscopically confirmed that the fiber dispersion was free from bound fibers. 2 parts of 0.005 % solution of polyethyleneimine (trade name: Epomin P-1000) (30 % stock solution; a product of Nippon Shokubai Co.) was added to the dispersion and then they were stirred to bundle the fibers. Thus, a fiber dispersion containing fiber bundles was prepared. A sheet was made from the fiber dispersion containing the fiber bundles by wet sheet making method with a square hand sheet making machine by using a 80 wire mesh plastic wire. Then the binder component was sprayed on the obtained wet sheet to adhere liquid binder A thereto. After drying with a dryer at 160°C for 10 minutes, a non-woven fabric having a basis weight of 50 g/m$^2$ and containing 50 % of the binder was obtained.

Liquid binder A:

100 parts of $\gamma$-ureidopropyltriethoxysilane (KBE-585; a product of Shin-Etsu Chemical Co., Ltd.) was mixed with 50 parts of water and 1 part of acetic acid at ambient temperature for 8 hours to obtain liquid binder A.

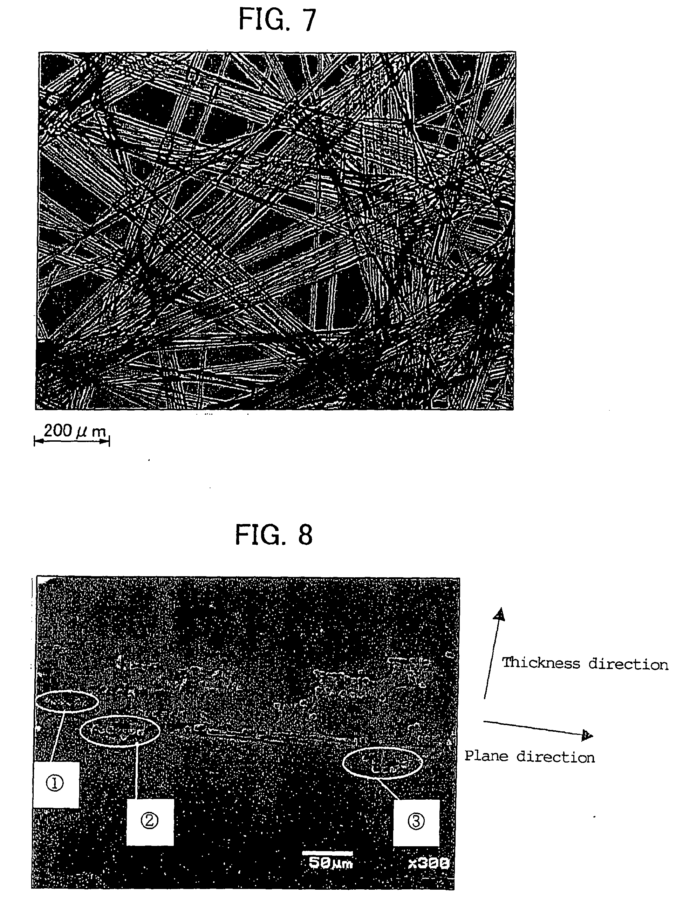

The thickness and bulk density of the obtained non-woven fabric were determined according to JIS P 8118 (50 kPa). The texture was macroscopically judged. The surface of each of five samples of non-woven fabric having a size of 1 cm × 1 cm was observed to find that the fibers were regularly bundled in the longitudinal direction in almost all the bundles as shown in Fig. 7 (a part of the observation). After the observation of the surface, the cross section of each of the 1 cm × 1 cm samples was observed by embedding the non-woven fabric in an embedding resin. The cross-section of the non-woven fabric was shaved with a microtome to obtain flakes, which were then observed with SEM (Back-Scattered Electron image). Fig. 8 shows one of the SEM (Back-Scattered Electron image) photographs and a typical example of a method for determining Z/X value. The average number of the bundled fibers, the maximum number of the bundled fibers, average Z/X value and the ratio of the number of non-bundled fibers to the total number of the glass fibers (rate of the non-bundled fibers) was determined by observing five cross-sections (0.5 mm$^2$) of the non-woven fabric. The results are shown in Table 1.

In Fig. 8;

① The number of fibers adjacent to each other in the thickness direction = 1, and the number of fibers adjacent to each other in the plane direction = 6 and, accordingly,

$$Z/X = 1/6$$

② The number of fibers adjacent to each other in the thickness direction = 2, and the number of fibers adjacent to each other in the plane direction = 7 and, accordingly,

$$Z/X = 2/7$$

③ The number of fibers adjacent to each other in the thickness direction = 2.5, and the number of fibers adjacent to each other in the plane direction = 6.5 and, accordingly,

$$Z/X = 2.5/6.5$$

<Example 2>

In this Example, a combination of a water-soluble anionic polymer and a nonionic surfactant was used as the dispersion stabilizer.

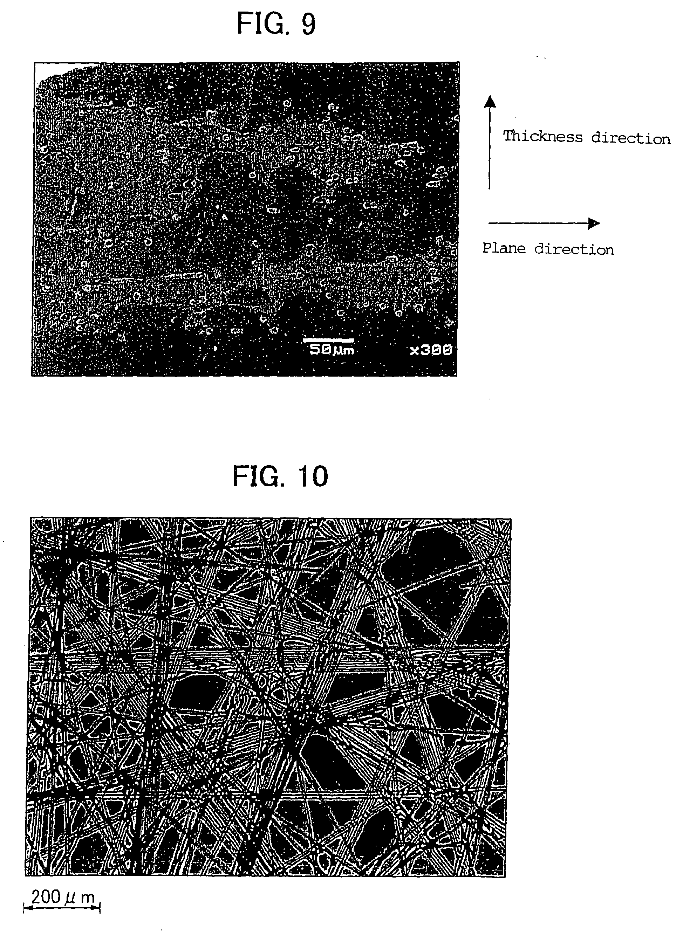

E glass fiber chops having a diameter of round cross-section ϕ of 13 μm and a fiber length of 9 mm were mixed with 1 %, based on the fibers, of a nonionic surfactant, i. e. polyethylene glycol stearate (Emanon 3299; a product of Kao Corporation). The obtained mixture was stirred in water with Three-one motor while the fiber concentration was kept at 0.02 %. Then 100 parts of the dispersion prepared as described above was mixed with 0.5 part of 0.1 % solution of a mixture of an anionic polyacrylamide (an anionic water-soluble polymer) and polysodium acrylate (ACCOPEARL R-200; a product of Mitsui Cytec Ltd.(Now: Mitsui Chemical Aqua Polymer Inc.)) to prepare a fiber dispersion. 1 parts of 0.005 % solution of polyethyleneimine (trade name: Epomin P-1000) (30 % stock solution; a product of Nippon Shokubai Co.) was added to the dispersion and then they were stirred to bundle the fibers. Thus, a fiber dispersion containing fiber bundles was prepared. A sheet was made from the fiber dispersion containing the fiber bundles by wet sheet making method with a square hand sheet making machine by using a 80 wire mesh plastic wire. Then an acrylic emulsion (A-104; a product of Toa Gosei Co.) as the binder component was sprayed on the obtained wet sheet to adhere the liquid binder thereto. After drying with a dryer at 160°C for 10 minutes, a non-woven fabric having a basis weight of 10 g/m$^2$ and containing 10 % of the binder was obtained. The surface of each of five samples of non-woven fabric having a size of 1 cm × 1 cm was observed to find that the fibers were regularly bundled in the longitudinal direction in almost all the bundles as shown in Fig. 10 (a part of the observation). The quality of the sheet was determined in the same manner as that in Example 1 to obtain the results shown in Table 1.

<Example 3>

In this Example, two dispersions, i. e. anionic fiber dispersion and cationic fiber dispersion, were prepared.

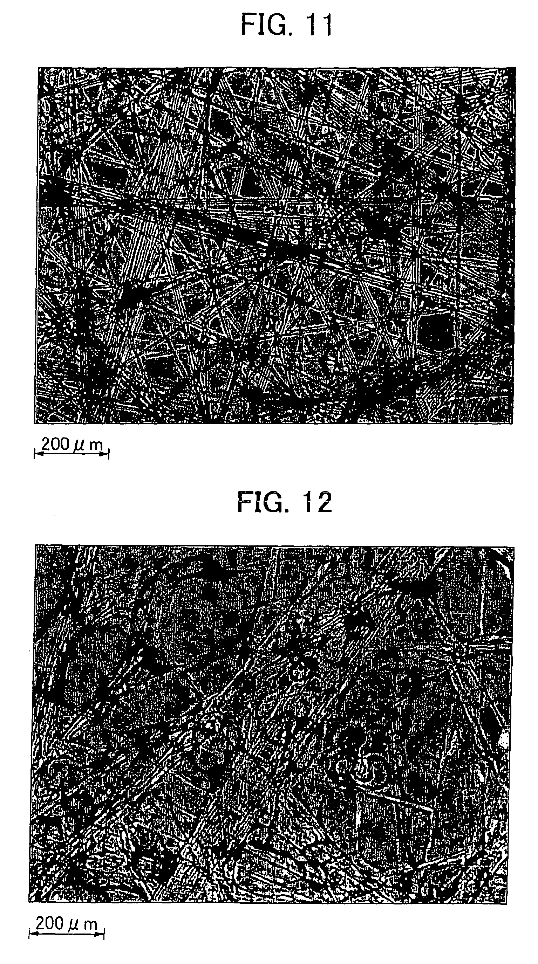

E glass fiber chops having a diameter of round cross-section ϕ of 6 μm and a fiber length of 3 mm were mixed with 1 %, based on the fibers, of polyethylene glycol stearate (Emanon 3299; a product of Kao Corporation) as a nonionic surfactant. The obtained mixture was stirred in water with Three-one motor while the fiber concentration was kept at 0.02 %. Then 100 parts of the dispersion prepared as described above was mixed with 0.5 part of 0.1 % solution of a mixture of an anionic polyacrylamide (an anionic water-soluble polymer) and polysodium acrylate (ACCOPEARL R-200; a product of Mitsui Cytec Ltd. (Now: Mitsui Chemical Aqua Polymer Inc.)) to prepare an anionic fiber dispersion. Then E glass fiber chops having a diameter of round cross-section ϕ of 6 μm and a fiber length of 3 mm were mixed with 0.5 %, based on the fibers, of an acrylamide / 2-(methacryloyloxy)ethyltrimethylammonium chloride copolymer (ACCURAC 206E; a product of Mitsui Cytec Ltd. (Now: Mitsui Chemical Aqua Polymer Inc.)) as a cationic polyacrylamide. The obtained mixture was stirred in water with Three-one motor while the fiber concentration was kept at 0.02 % to prepare a cationic fiber dispersion. Then 70 parts of the anionic fiber dispersion prepared as described above was mixed with 30 parts of the cationic fiber dispersion prepared as described above to bundle the fibers. A sheet was made from the fiber dispersion containing the fiber bundles by wet sheet making method with a square hand sheet making machine by using a 80 wire mesh plastic wire. Then a filter paper was placed on the obtained wet sheet and the wet sheet was pressed with a metal roll having a diameter of 10 cm, length of 30 cm and weight of 20 kg by reciprocating it twice. An acrylic emulsion (A-104; a product of Toa Gosei Co.) as the binder component was sprayed on the obtained sheet to adhere the emulsion thereto. After drying with a dryer at 160°C for 10 minutes, a non-woven fabric having a basis weight of 20 g/m$^2$ and containing 10 % of the binder was obtained. The surface of each of five samples of non-woven fabric having a size of 1 cm $\times$ 1 cm was observed to find that the fibers were regularly bundled in the longitudinal direction in almost all the bundles as shown in Fig. 11 (a part of the observation). The quality of the sheet was determined in the same manner as that in Example 1 to obtain the results shown in Table 1.

<Example 4>

In this Example, a combination of a cationic polyethyleneimine and a nonionic surfactant was used as the dispersion stabilizer.

E glass fiber chops having a diameter of round cross-section $\phi$ of 13 $\mu$m and a fiber length of 9 mm were mixed with E glass fiber chops having a diameter of round cross-section $\phi$ of 6 $\mu$m and a fiber length of 3 mm in a mass ratio of 1:1. The mixed fiber chops were then mixed with 1 %, based on the fibers, of a nonionic surfactant, i. e. polyethylene glycol stearate (Emanon 3299; a product of Kao Corporation). Then 0.3 %, based on the fibers, of polyethyleneimine (trade name: Epomin P-1000) (30 % stock solution; a product of Nippon Shokubai Co.) was added to the fibers. The obtained mixture was stirred in water with Three-one motor while the fiber concentration was kept at 0.02 %. It was macroscopically confirmed that the fiber dispersion was free from bound fibers. Then 100 parts of the dispersion prepared as described above was stirred together with 0.5 part of 0.1 % solution of a mixture of an anionic polyacrylamide (an anionic water-soluble polymer) and polysodium acrylate (ACCOPEARL R-200; a product of Mitsui Cytec Ltd. (Now: Mitsui Chemical Aqua Polymer Inc.)) to bundle the fibers. Thus, a fiber dispersion containing fiber bundles was prepared. A sheet was made from the fiber dispersion containing the fiber bundles by wet sheet making method with a square hand sheet making machine by using a 80 wire mesh plastic wire. Then the binder component was sprayed on the obtained wet sheet to adhere liquid binder B thereto. After drying with a dryer at 160°C for 10 minutes, a non-woven fabric having a basis weight of 70.7 g/m$^2$ and containing 80 % of the binder was obtained. The surface of each of five samples of non-woven fabric having a size of 1 cm $\times$ 1 cm was observed to find that the fibers were regularly bundled in the longitudinal direction in almost all the bundles as shown in Fig. 12 (a part of the observation). The quality of the sheet was determined in the same manner as that in Example 1 to obtain the results shown in Table 1.

Liquid binder B:

100 parts of alkoxysilane composed of 40 parts of ethyl silicate (Ethyl silicate 40; a product of COLCOAT CO., LTD.) and 60 parts of N-β -aminoethyl- γ -aminopropylmethoxysilane (KBM603; a product of Shin-Ethu Chemical Co., Ltd.), 5 parts of 1 N hydrochloric acid, 100 parts of water and 80 parts of isopropyl alcohol were mixed together. The obtained mixture was stirred while the temperature was kept at 80°C in a reactor provided with a reflux tube for 30 minutes and then cooled to room temperature to obtain liquid binder B.

<Example 5>

In this Example, a cationic polyacrylamide was used as the dispersion stabilizer.

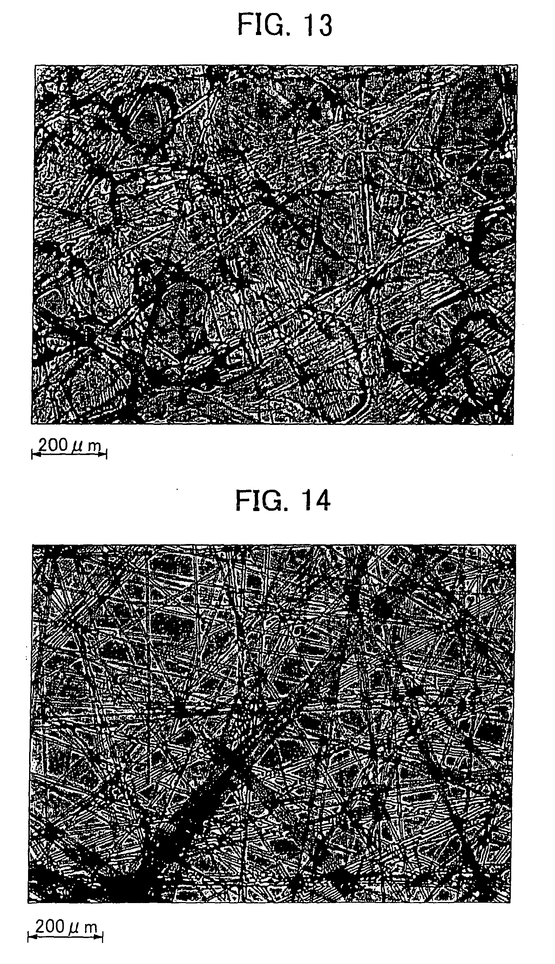

E glass fiber chops having a diameter of round cross-section $\phi$ of 6 $\mu$m and a fiber length of 3 mm were mixed with 0.5 %, based on the fibers, of acrylamide / 2-(methacryloyloxy)ethyltrimethylammonium chloride copolymer (ACCURAC 206E; a product of Mitsui Cytec Ltd. (Now: Mitsui Chemical Aqua Polymer Inc.)) as a cationic polyacrylamide. The obtained mixture was stirred in water with Three-one motor while the fiber concentration was kept at 0.02 %. It was macroscopically confirmed that the fiber dispersion was free from bound fibers. Then 100 parts of the dispersion prepared as described above was stirred together with 0.5 part of 0.1 % solution of an anionic polyacrylamide (an anionic water-soluble polymer) (SUMIFLOC FA40H; a product of Sumitomo Chemical Co., Ltd.) to bundle the fibers. Thus, a fiber dispersion containing fiber bundles was prepared. A sheet was made from the fiber dispersion containing the fiber bundles by wet paper making method with a square hand sheet making machine by using a 80 mesh plastic wire. Then the binder component was sprayed on the obtained wet sheet to adhere liquid binder B thereto. After drying with a dryer at 160°C for 10 minutes, a non-woven fabric having a basis weight of 40 g/m$^2$ and containing 70 % of the binder was obtained. The surface of each of five samples of non-woven fabric having a size of 1 cm × 1 cm was observed to find that the fibers were regularly bundled in the longitudinal direction in almost all the bundles as shown in Fig. 13 (a part of the observation). The quality of the sheet was determined in the same manner as that in Example 1 to obtain the results shown in Table 1.

<Example 6>

In this Example, a combination of a cationic polyethyleneimine and a nonionic surfactant was used as the dispersion stabilizer.

E glass fiber chops having a diameter of round cross-section $\phi$ of 13 $\mu$m and a fiber length of 9 mm were mixed with E glass fiber chops having a diameter of round cross-section $\phi$ of 6 $\mu$m and a fiber length of 3 mm in a mass ratio of 1:1. The mixed fiber chops were then mixed with 1 %, based on the fibers, of a nonionic surfactant, i. e. polyethylene glycol stearate (Emanon 3299; a product of Kao Corporation). Then 0.1 %, based on the fibers, of polyethyleneimine (trade name: Epomin P-1000) (30 % stock solution; a product of Nippon Shokubai Co.) was added to the fibers. The obtained mixture was stirred in water with Three-one motor while the fiber concentration was kept at 0.02 %. It was macroscopically confirmed that the fiber dispersion was free from bound fibers. Then 100 parts of the dispersion prepared as described above was stirred together with 0.1 part of 0.1 % solution of a mixture of an anionic polyacrylamide (an anionic water-soluble polymer) and polysodium acrylate (ACCOPEARL R-200; a product of Mitsui Cytec Ltd. (Now: Mitsui Chemical Aqua Polymer Inc.)) to bundle the fibers. Thus, a fiber dispersion containing fiber bundles was prepared. A sheet was made from the fiber dispersion containing the fiber bundles by wet sheet making method with a square hand paper making machine by using a 80 wire mesh plastic wire. Then an acryl emulsion (A-104; a product of Toa Gosei Co.) as the binder component was sprayed on the obtained wet sheet to adhere the binder thereto. After drying with a dryer at 160°C for 10 minutes, a non-woven fabric having a basis weight of 20 g/m$^2$ and containing 10 %) of the binder was obtained. The surface of each of five samples of non-woven fabric having a size of 1 cm × 1 cm was observed to find that the fibers were regularly bundled in the longitudinal direction in almost all the bundles as shown in Fig. 14 (a part of the observation). The quality of the sheet was determined in the same manner as that in Example 1 to obtain the results shown in Table 1.

<Example 7>

E glass fiber chops having a diameter of round cross-section $\phi$ of 13 $\mu$m and a fiber length of 9 mm were mixed with E glass fiber chops having a diameter of round cross-section $\phi$ of 6 $\mu$m and a fiber length of 3 mm in a mass ratio of 1:1. The mixed fiber chops were then mixed with 1 %, based on the fibers, of polyethylene glycol stearate (Emanon 3299; a product of Kao Corporation). Then 0.05 %, based on the fibers, of polyethyleneimine (trade name: Epomin P-1000) (30 % stock solution; a product of Nippon Shokubai Co.) was added to the fibers. The obtained mixture was stirred in water with Three-one motor while the fiber concentration was kept at 0.02 %. It was macroscopically confirmed that the fiber dispersion was free from bound fibers. Then 100 parts of the dispersion prepared as described above was stirred together with 0.5 part of 0.1 % solution of an anionic polyacrylamide (an anionic water-soluble polymer) (SUMIFLOC A40H; a product of Sumitomo Chemical Co., Ltd.) to bundle the fibers. Thus, a fiber dispersion containing fiber bundles was prepared. A sheet was made from the fiber dispersion containing the fiber bundles by wet sheet making method with a square hand paper making machine by using a 80 wire mesh plastic wire. Then an acryl emulsion (A-104; a product of Toa Gosei Co.) as the binder component was sprayed on the obtained wet sheet to adhere the binder thereto. After drying with a dryer at 160°C for 10 minutes, a non-woven fabric having a basis weight of 50 g/m$^2$ and containing 10 % of the binder was obtained. The thickness and bulk density of the obtained non-woven fabric were determined according to JIS P-8118 (50 kPa). The texture was macroscopically judged. The average number of the bundled fibers, the maximum number of the bundled fibers, average Z/X value, etc. were calculated as in Example 1 to obtain the results shown in Table 1.

<Example 8>

E glass fiber chops having a diameter of round cross-section $\phi$ of 6 $\mu$m and a fiber length of 3 mm were mixed with 1 %, based on the fibers, of a nonionic surfactant, i. e. polyethylene glycol stearate (Emanon 3299; a product of Kao Corporation). The obtained mixture was stirred in water with Three-one motor while the fiber concentration was kept at 0.02 %. Then 0.2 part of 0.1 % solution of an anionic polyacrylamide (an anionic water-soluble polymer) (SUMIFLOC FA40H; a product of Sumitomo Chemical Co., Ltd.) was added to 100 parts of the dispersion to prepare a fiber dispersion. It was macroscopically confirmed that the fiber dispersion was free from bound fibers. 0.2 part of 0.0005 % solution of polyethyleneimine (trade name: Epomin P-1000) (30 % stock solution; a product of Nippon Shokubai Co.) was added to the dispersion and the resultant mixture was stirred to bundle the fibers. Thus, a fiber dispersion containing fiber bundles was prepared. A sheet was made from the fiber dispersion containing the fiber bundles by wet paper making method with a square hand sheet making machine by using a 80 mesh plastic wire. Then an acryl emulsion (A-104; a product of Toa Gosei Co.) as the binder component was sprayed on the obtained wet sheet to adhere the binder thereto. After drying with a dryer at 160°C for 10 minutes, a non-woven fabric having a basis weight of 50 g/m$^2$ and containing 10 % of the binder was obtained. The thickness and bulk density of the obtained non-woven fabric were determined according to JIS P-8118 (50 kPa). The average number of the bundled fibers, the maximum number of the bundled fibers, average Z/X value, etc. were calculated as in Example 1 to obtain the results shown in Table 1.

<Comparative Example 1>

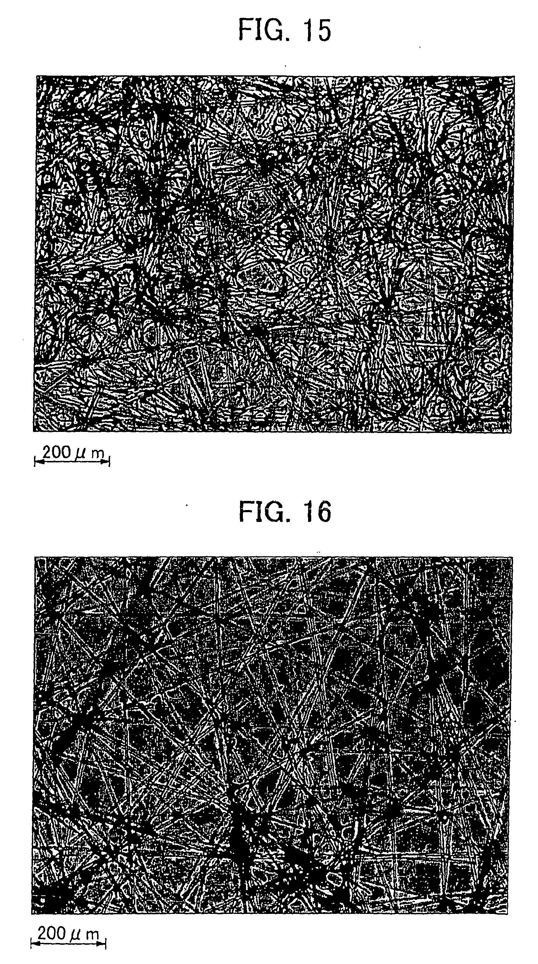

A non-woven fabric was prepared in the same manner as that in Example 1 except that the polyethyleneimine was not added and the step of bundling the fibers was omitted. Then the quality of the sheet was examined. The results are shown in Table 1. One of the photographs of the surface of the non-woven fabric and one of the photographs of the section are shown in Figs. 9 and 15, respectively. It will be understood from them that they are substantially free from the bundled fibers.

<Comparative Example 2>

A non-woven fabric was prepared in the same manner as that in Example 2 except that the polyethyleneimine was not added and the step of bundling the fibers was omitted. Then the quality of the sheet was examined. The results are shown in Table 1. One of the photographs of the surface of the non-woven fabric is shown in Fig. 16. It will be understood from the photograph that it is substantially free from the bundled fibers.

<Comparative Example 3>

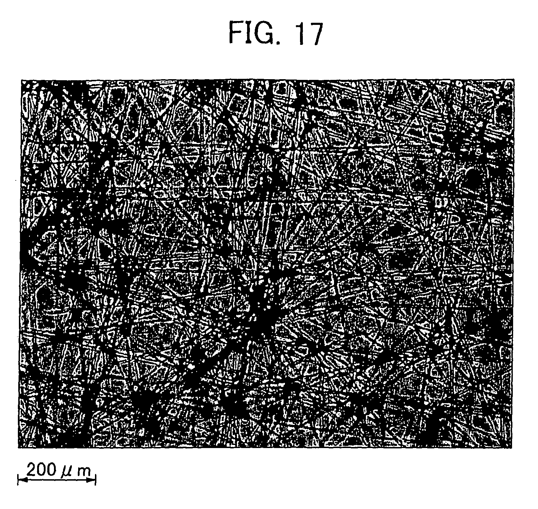

A non-woven fabric was prepared in the same manner as that in Example 6 except that the water-soluble anionic polymer was not added and that the step of bundling the fibers was omitted. Then the quality of the sheet was examined. The results are shown in Table 1. One of the photographs of the surface of the non-woven fabric is shown in Fig. 17. It will be understood from the photograph that it is substantially free from the bundled fibers.

Table 1

| | Example | | | | | | | |
|---|---|---|---|---|---|---|---|---|
| | 1 | 2 | 3 | 4 | 5 | 6 | 7 | 8 |
| Thickness (μm) | 125 | 40 | 60 | 70 | 55 | 87 | 263 | 294 |
| Density (g/cm$^3$) | 0.40 | 0.25 | 0.33 | 1.01 | 0.73 | 0.23 | 0.19 | 0.17 |
| Average number of fibers in the bundle | 4.3 | 8.7 | 4.6 | 7.7 | 11.3 | 2.1 | 2.0 | 1.6 |
| Maximum number of fibers in the bundle | 19 | 43 | 24 | 59 | 93 | 15 | 9 | 5 |
| Average Z/X | 0.70 | 0.74 | 0.55 | 0.46 | 0.37 | 0.84 | 0.85 | 0.88 |
| Rate of non-bundled fibers (%) | 10.1 | 6.2 | 12.2 | 5.2 | 3.2 | 29.3 | 34.6 | 46.7 |
| Formation | good | good | good | good | good | good | good | good |
| Inorganic fiber in waste water | none | none | none | none | none | none | none | none |

14

Table 1 (continued)

| | Comparative Example | | |
|---|---|---|---|
| | 1 | 2 | 3 |
| Thickness (μm) | 260 | 70 | 135 |
| Density (g/cm³) | 0.19 | 0.14 | 0.15 |
| Average number of fibers in the bundle | 1.2 | 1.1 | 1.3 |
| Maximum number of fibers in the bundle | 1 | 1 | 2 |
| Average Z/X | 0.98 | 0.98 | 0.95 |
| Rate of non-bundled fibers (%) | 72.0 | 80.6 | 86.7 |
| Formation | good | good | good |
| Inorganic fiber in waste water | none | none | none |

According to the present invention, it is made possible to provide industrially very useful non-woven inorganic fiber fabrics having a high density.

**Claims**

1. A wet-spun non-woven fabric composed of inorganic fibers containing bundled inorganic fibers and a binder component for binding the fibers, wherein an average number of the fibers in each bundle is 1.5 to 20 and an average Z/X value represented by the following formula in the cross section of the non-woven fabric is 0.9 or below:

(number of adjacent fibers in the thickness direction in each bundle) / (number of adjacent fibers in the plane direction in each bundle) = Z/X.

2. The wet-spun non-woven fabric of claim 1 wherein the maximum number of fibers in the bundle is not larger than 100.

3. The wet-spun non-woven fabric of claim 1 or 2 wherein the average diameter of the inorganic fibers is 4 μm to 20 μm and the average fiber length is 1 mm to 25 mm.

4. The wet-spun non-woven fabric of any of claims 1 to 3 wherein the inorganic fibers are glass fibers.

5. The wet-spun non-woven fabric of any of claims 1 to 4, which has a density of 0.20 g/cm³ to 1.20 g/cm³.

6. The wet-spun non-woven fabric of any of claims 1 to 5, which has a binder content of 3 % by mass to 18 % by mass and a density of 0.20 g/cm³ to 0.50 g/cm³.

7. The wet-spun non-woven fabric of any of claims 1 to 5, which has a binder content of 50 % by mass to 90 % by mass and a density of 0.40 g/cm³ to 1.20 g/cm³.

8. A method for producing a wet-spun non-woven fabric of any of claims 1 to 7, which comprises the steps of dispersing inorganic fibers in an aqueous medium in the presence of an anionic dispersion stabilizer, adding a cationic compound to the obtained fiber dispersion to bundle the fibers and thereby preparing a fiber dispersion containing the resultant fiber bundles, making a sheet from the obtained fiber dispersion containing the fiber bundles by wet method and applying a binder to the obtained sheet.

9. A method for producing a wet-spun non-woven fabric of any of claims 1 to 7, which comprises the steps of dispersing inorganic fibers in an aqueous medium in the presence of a cationic dispersion stabilizer, adding an anionic compound to the obtained fiber dispersion to bundle the fibers and thereby preparing a fiber dispersion containing the resultant fiber bundles, making a sheet from the obtained fiber dispersion containing the fiber bundles by wet method and applying a binder to the obtained sheet.

10. A method for producing a wet-spun non-woven fabric of any of claims 1 to 7, which comprises the steps of dispersing a part of inorganic fibers in an aqueous medium in the presence of an anionic dispersion stabilizer to prepare an anionic fiber dispersion, dispersing a part of the inorganic fibers or the remainder of the inorganic fibers in an aqueous medium in the presence of a cationic dispersion stabilizer to prepare a cationic fiber dispersion and thereby preparing at least two fiber dispersions, mixing the at least two fiber dispersions together to bundle the fibers and to prepare a fiber dispersion containing the fiber bundles, making a sheet from the obtained fiber dispersion containing the fiber bundles by wet method and applying a binder to the obtained sheet.

11. Prepregs and/or laminates containing the wet-spun non-woven fabric of any of claims 1 to 7.

12. Prepregs and/or laminates for printed circuits, which contain the wet-spun non-woven fabric having a thickness of 300 $\mu$m or less of any of claims 1 to 7.

13. A method for producing a wet-spun non-woven fabric, which comprises the steps of dispersing inorganic fibers in an aqueous medium in the presence of an anionic dispersion stabilizer and a nonionic surfactant, adding a polyethyleneimine to the obtained fiber dispersion to bundle the fibers and thereby preparing a fiber dispersion containing the resultant fiber bundles, making a sheet from the obtained fiber dispersion containing the fiber bundles by wet method and applying a binder to the obtained sheet.

14. A method for producing a wet-spun non-woven fabric, which comprises the steps of dispersing inorganic fibers in an aqueous medium in the presence of a polyethyleneimine and a nonionic surfactant, adding an anionic compound to the obtained fiber dispersion to bundle the fibers and thereby preparing a fiber dispersion containing the resultant fiber bundles, making a sheet from the obtained fiber dispersion containing the fiber bundles by wet method and applying a binder to the obtained sheet.

# FIG. 1

# FIG. 2

# FIG. 3

## FIG. 4

Fiber β

Fiber α

d          e

## FIG. 5

Fiber β

Fiber α

## FIG. 6

Fiber β

Fiber α

## FIG. 7

|←— 200 μm —→|

## FIG. 8

Thickness direction

Plane direction

## FIG. 9

Thickness direction

Plane direction

50μm    x300

## FIG. 10

200 μ m

# FIG. 11

200 μm

# FIG. 12

200 μm

## FIG. 13

200 μ m

## FIG. 14

200 μ m

## FIG. 15

200 µm

## FIG. 16

200 µm

FIG. 17

200 μm

<div align="center">

**INTERNATIONAL SEARCH REPORT**

</div>

| | International application No. |
|---|---|
| | PCT/JP2004/005742 |

| A. CLASSIFICATION OF SUBJECT MATTER |
|---|
| Int.Cl⁷ D21H13/40, B29B11/16, H05K1/03 |

According to International Patent Classification (IPC) or to both national classification and IPC

| B. FIELDS SEARCHED |
|---|
| Minimum documentation searched (classification system followed by classification symbols) |
| Int.Cl⁷ D21H13/40, B29B11/16, H05K1/03 |

Documentation searched other than minimum documentation to the extent that such documents are included in the fields searched

| Jitsuyo Shinan Koho | 1926–1996 | Toroku Jitsuyo Shinan Koho | 1994–2004 |
|---|---|---|---|
| Kokai Jitsuyo Shinan Koho | 1971–2004 | Jitsuyo Shinan Toroku Koho | 1996–2004 |

Electronic data base consulted during the international search (name of data base and, where practicable, search terms used)
WPIL, D21H13/40

| C. DOCUMENTS CONSIDERED TO BE RELEVANT |
|---|

| Category* | Citation of document, with indication, where appropriate, of the relevant passages | Relevant to claim No. |
|---|---|---|
| A | JP 2000-308805 A (Nippon Sheet Glass Co., Ltd.), 07 November, 2000 (07.11.00), Full text (Family: none) | 1-14 |
| A | JP 2002-88627 A (Johns Manville International, Inc.), 27 March, 2002 (27.03.02), Full text & EP 1174541 A2 & US 6548155 B | 1-14 |
| A | JP 2002-127136 A (Asahi Fiber Glass Co., Ltd.), 08 May, 2002 (08.05.02), Full text (Family: none) | 1-14 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 15 July, 2004 (15.07.04) | 03 August, 2004 (03.08.04) |

| Name and mailing address of the ISA/ | Authorized officer |
|---|---|
| Japanese Patent Office | |
| Facsimile No. | Telephone No. |

Form PCT/ISA/210 (second sheet) (January 2004)

<table>
<tr><td colspan="2" align="center">**INTERNATIONAL SEARCH REPORT**</td><td>International application No.<br>PCT/JP2004/005742</td></tr>
</table>

C (Continuation). DOCUMENTS CONSIDERED TO BE RELEVANT

| Category* | Citation of document, with indication, where appropriate, of the relevant passages | Relevant to claim No. |
|---|---|---|
| A | JP 2002-61093 A (Nippon Electric Glass Co., Ltd.),<br>28 February, 2002 (28.02.02),<br>Full text<br>(Family: none) | 1-14 |
| A | WO 01/75204 A2 (AHLSTROM GLASSFIBRE OY),<br>11 October, 2001 (11.10.01),<br>Full text; Figs. 1 to 5<br>& JP 15-529684 A & US 2002-92634 A1<br>& EP 1272701 A | 1-14 |
| A | JP 9-208252 A (Nitto Boseki Co., Ltd.),<br>12 August, 1997 (12.08.97),<br>Full text<br>(Family: none) | 1-14 |
| A | JP 5-140336 A (Kawasaki Steel Corp.),<br>08 June, 1993 (08.06.93),<br>Full text; Fig. 1<br>(Family: none) | 1-14 |

Form PCT/ISA/210 (continuation of second sheet) (January 2004)